# EUROPEAN PATENT APPLICATION

(11) **EP 2 280 458 A1**
(43) Date of publication of application: **02.02.2011**
(21) Application number: 09742660.5
(22) Date of filing: 16.04.2009
(51) Int. Cl.: H01T 4/10, H01L 23/00, H01T 4/12, H05K 1/02

(54) **SUBSTRATE INCORPORATING ESD PROTECTION FUNCTION**

(30) Priority: 08.05.2008 JP 2008122801
(71) Applicant: Murata Manufacturing Co. Ltd., Kyoto 617-8555 (JP)
(72) Inventor: NOMA, Takashi, Nagaokakyo-shi Kyoto 617-8555 (JP); URAKAWA, Jun, Nagaokakyo-shi Kyoto 617-8555 (JP)
(74) Representative: Schenk, Markus
(86) International application number: PCT/JP2009/057700
(87) International publication number: WO 2009/136535

(57) **Abstract**

This invention provides a structure in which the size of a circuit is easily reduced and an ESD protection function can be sufficiently demonstrated.

In an insulating substrate 12, at least one of circuit elements 24 and 26 or a wiring pattern 28 and an ESD protection portion 30 is incorporated. In the ESD protection portion 30, facing portions of at least one pair of discharge electrodes are disposed in a cavity formed in the insulating substrate 12 so that the tope ends face each other. The discharge electrodes are electrically connected to the circuit elements 24 and 26 or the wiring pattern 28.

## Description

### Technical Field

The present invention relates to a substrate incorporating an ESD protection function.

### Background Art

ESD (Electro-Static Discharge) refers to a phenomena in which intense discharge occurs when electrically charged conductive substances (e.g., human body) contact or sufficiently approach other conductive substances (e.g., electronic devices). The ESD causes problems, such as damages to electronic devices or malfunction thereof. In order to prevent the problems, it is required that an excessive voltage generating during discharge is not applied to circuits of electronic devices. For such a purpose, an ESD protection device is used, and is also referred to as a surge absorption element or a serge absorber.

The ESD protection device is disposed, for example between a signal line and a ground of a circuit. The ESD protection device having a structure in which a pair of discharge electrodes is disposed with a space facing each other has a high resistance in normal use and a signal does not flow to a ground side. In contrast, when an excessive voltage is applied similarly as in the case where static electricity is applied from an antenna of a cellular phone, for example, discharge occurs between the discharge electrodes of the ESD protection device, and thus static electricity can be led to the ground side. Thus, a circuit at a latter stage of the ESD device, a voltage generated by static electricity is not applied, and thus the circuit can be protected.

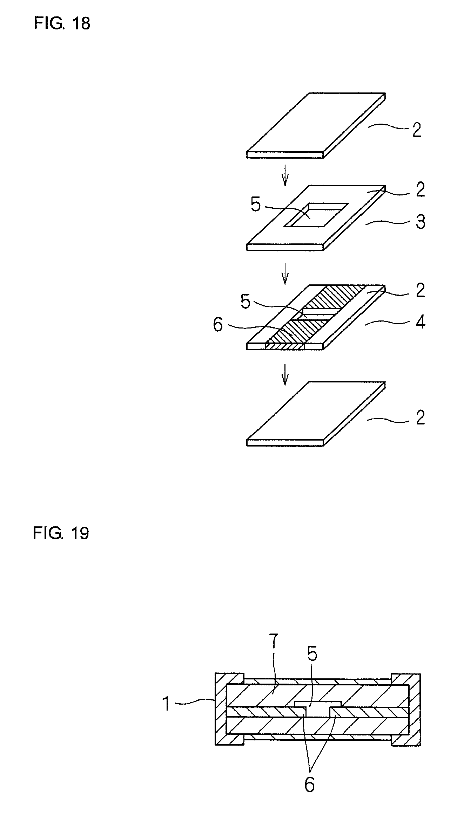

For example, in an ESD protection device shown in an exploded perspective view of Fig. 18 and a cross sectional view of Fig. 19, a cavity 5 is formed in a ceramic multilayer substrate 7 in which two or more insulating ceramic sheets 2 are laminated, discharge electrodes 6 electrically connected to external electrodes 1 are disposed facing each other in the cavity 5, and a discharge gas is enclosed in the cavity 5. When a voltage causing dielectric breakdown between the discharge electrodes 6 is applied, discharge occurs between the discharge electrodes 6 in the cavity 5. The discharge leads an excessive voltage to the ground, and thus a circuit in a latter stage can be protected (e.g., Patent Document 1).

[Patent Document 1]: Japanese Unexamined Patent Application Publication No. 2001-43954

### Problems to be Solved by the Invention

However, when the ESD protection device is mounted, a space for the ESD protection device is required, which results in the fact that the size of a circuit is difficult to reduce. Moreover, the wiring distance from the ESD protection device to electronic circuits or electronic components to be protected becomes long, and thus the ESD protection performance is not sufficiently demonstrated due to the influence of wiring impedance in some cases.

In view of the above-described circumstances, it is an object of the invention to provide a structure in which the size of a circuit can be easily reduced and the ESD protection function can be sufficiently demonstrated. Means for Solving the Problems

The present invention provides a substrate incorporating an ESD protection function structured as follows in order to solve the above-described problems.

A substrate incorporating an ESD protection function has (a) an insulating substrate incorporating at least one of a circuit element or a wiring pattern, (b) at least one cavity formed in the insulating substrate, and (c) at least one pair of discharge electrodes having facing portions disposed in the cavity so that the top ends thereof face each other with a space and being electrically connected to the circuit element or the wiring pattern.

In the structure, due to the fact that the facing portions of the discharge electrodes are disposed in the cavity formed in the insulating substrate, an ESD protection portion is formed. More specifically, when a voltage exceeding a given voltage is applied between the discharge electrodes, the space between the top ends of the facing portions of the discharge electrodes is short-circuited, and functions as an ESD protection portion.

According to the structure, compared with the case where a separate and independent ESD protection device is used, a mounting area can be reduced by integrating the ESD protection portion and the insulating substrate, and thus a reduction in the size of the circuit is facilitated. Moreover, the wiring distance can be shortened and the ESD protection function can be sufficiently demonstrated.

Moreover, since the separate and independent ESD protection device is also produced using a substrate, a substrate incorporating an ESD protection function can be produced by integrating the ESD protection portion and the insulating substrate without increasing the number of processes.

Preferably, the insulating substrate has a mixed portion. The mixed portion is disposed near the surface where the discharge electrodes are provided, the mixed portion is disposed adjacent at least to the facing portions of the discharge electrodes and a portion between the facing portions. The mixed portion contains a metal material and an insulating material constituting the insulating substrate.

In the structure, the mixed portion is disposed between the facing portions of the discharge electrodes and the insulating substrate. Since the mixed portion contains metal materials that are the same as or similar to materials of the discharge electrodes and insulating materials that are the same as or similar to materials of the insulating substrate, the coefficient of thermal expansion of the mixed portion can be adjusted to be an intermediate value between the coefficient of thermal expansion of the facing portions of the discharge electrode and the coefficient of thermal expansion of the insulating substrate. Thus, differences in the coefficient of thermal expansion between the facing portions of the discharge electrodes and the insulating substrate can be reduced by the mixed portion, and defects caused by separation or the like of the discharge electrodes or aged deterioration of the characteristics can be made small.

The mixed portion containing metal materials is disposed adjacent to the facing portions of the discharge electrodes in which discharge occurs. Thus, by adjusting the amount, type, or the like of the metal materials contained in the mixed portion, the firing potential can be set to a desired value. Thus, the firing potential can be set up with favorable accuracy rather than the case where the firing potential is adjusted simply by varying the interval between the facing portions of the discharge electrodes.

Preferably, the mixed portion is disposed adjacent only to the facing portions and the space between the facing portions.

In this case, since the mixed portion containing metal materials is not disposed at peripheral regions other than the region adjacent to the facing portions and the space between the facing portions of the discharge electrodes, the electric characteristics, such as a dielectric constant, or the mechanical strength of the insulating substrate of the peripheral regions do not reduce due to the metal materials of the mixed portion.

Preferably, when viewed in the direction in which the facing portions of the discharge electrodes and the mixed portion are overlapped with each other, the mixed portion is formed in contact with the periphery of the cavity and only inside the periphery.

In this case, since the mixed portion is formed only directly under the cavity, a variation in the interval between the facing portions of the discharge electrodes becomes small, and the firing potential can be adjusted with sufficient accuracy.

Preferably, the insulating substrate is a ceramic substrate.

The ceramic substrate is easy to form a cavity therein or form a circuit element or a wiring pattern therein by laminating two or more base material layers and firing the laminate, and thus is suitable for an insulating substrate of a substrate incorporating an ESD protection function.

Preferably, the cavity and the discharge electrode are formed near a signal input portion of the insulating substrate.

In this case, by reducing the wiring distance from the signal input portion of the insulating substrate to the ESD protection portion as much as possible, a reduction in the ESD protection performance due to the influence of wiring impedance can be prevented. For example, when the ESD protection portion is disposed between the signal input portion of the insulating substrate and a circuit element formed in the insulating substrate or an electronic component mounted on the insulating substrate, the ESD protection performance can be sufficiently demonstrated to the circuit element formed in the insulating substrate or the electronic component mounted on the insulating substrate.

Preferably, the circuit element or the wiring pattern constitutes a high frequency circuit.

Compared with the case where a varistor or a zener diode is used for ESD protection, the present invention can make the capacity of the ESD protection portion very small, and thus can sufficiently demonstrate the ESD protection function to a high frequency circuit. For example, the ESD protection function can be sufficiently demonstrated to a high frequency circuit of 300 MHz to several GHz.

Preferably, an IC is mounted on the insulating substrate or in the insulating substrate.

In this case, the mounted IC normally operates even at a high frequency because the capacity of the ESD protection is small. Compared with the case where a separate and independent ESD protection device is used, a degradation of the protection function due to the wiring impedance between the ESD protection portion and the Ic can be reduced by reducing the distance therebetween.

### Advantages

The substrate incorporating an ESD protection function of the present invention can easily reduce the size of a circuit and can sufficiently demonstrate an ESD protection function.

### Brief Description of Drawings

[Fig. 1] Fig. 1 is an outline view illustrating the structure of a substrate incorporating an ESD protection function. (Example 1)
[Fig. 2] Fig. 2 is an electric circuit diagram illustrating the structure of the substrate incorporating an ESD protection function. (Example 1)
[Fig. 3] Fig. 3 is a cross sectional view illustrating the structure of an ESD protection portion. (Example 1)
[Fig. 4] Fig. 4 is a cross sectional view along the A-A line of Fig. 3. (Example 1)
[Fig. 5] Fig. 5 is a perspective view of a substrate incorporating an ESD protection function. (Example 2)
[Fig. 6] Fig. 6 is an electric circuit diagram illustrating the structure of the substrate incorporating an ESD protection function. (Example 2)
[Fig. 7] Fig. 7 is an outline view illustrating the structure of a substrate incorporating an ESD protection function. (Example 3)
[Fig. 8] Fig. 8 is an electric circuit diagram illustrating the structure of the substrate incorporating an ESD protection function. (Example 3)
[Fig. 9] Fig. 9 is an exploded perspective view illustrating the structure of a substrate incorporating an ESD protection function. (Example 4)
[Fig. 10] Fig. 10 is an electric circuit diagram illustrating the structure of the substrate incorporating an ESD protection function. (Example 4)
[Fig. 11] Fig. 11 is a schematic diagram illustrating the structure of a substrate incorporating an ESD protection function. (Example 5)
[Fig. 12] Fig. 12 is an electric circuit diagram illustrating the structure of the substrate incorporating an ESD protection function. (Example 5)
[Fig. 13] Fig. 13 is an outline view illustrating the structure of a substrate incorporating an ESD protection function. (Example 6)
[Fig. 14] Fig. 14 is a cross sectional view illustrating the structure of an ESD protection portion. (Modification 1)
[Fig. 15] Fig. 15 is a cross sectional view illustrating the structure of an ESD protection portion. (Modification 2)
[Fig. 16] Fig. 16 is a cross sectional view illustrating the structure of an ESD protection portion. (Modification 3)
[Fig. 17] Fig. 17 is a cross sectional view illustrating the structure of an ESD protection portion. (Modification 4)
[Fig. 18] Fig. 18 is an exploded perspective view of an ESD protection device. (Former Example)
[Fig. 19] Fig. 19 is a cross sectional view of the ESD protection device. (Former example)

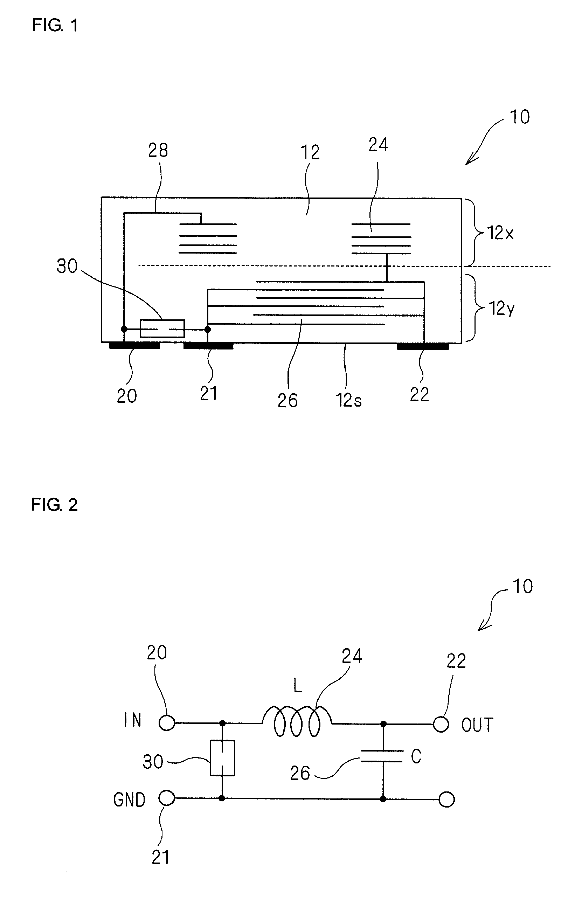

Hereinafter, embodiments of the present invention will be described with reference to Figs. 1 to 17.

### <Example 1>

A substrate 10 incorporating an ESD protection function of Example 1 will be described with reference to Figs. 1 to 4.

First, the whole structure of the substrate 10 incorporating an ESD protection function of Example 1 will be described with reference to Figs. 1 and 2. Fig. 1 is an outline view schematically illustrating the cross-sectional structure of the substrate 10 incorporating an ESD protection function. Fig. 2 is an electric circuit diagram illustrating the circuit structure of the substrate 10 incorporating an ESD protection function.

As illustrated in Figs. 1 and 2, the substrate 10 incorporating an ESD protection function has a ceramic multilayer substrate 12 obtained by laminating two or more base material layers in which an inductor element 24 and a capacitor element 26 as circuit elements, a wiring pattern 28, and an ESD protection portion 30 are formed. On a lower surface 12s of the ceramic multilayer substrate 12, external electrodes 20, 21, and 22 are formed that are used for mounting the substrate 10 incorporating an ESD protection function on another circuit substrate.

The inductor element 24 is formed in an upper portion 12x of the ceramic multilayer substrate 12 and the capacitor element 26 is formed in a lower portion 12y of the ceramic multilayer substrate 12. The inductor element 24 and the capacitor element 26 constitute a low pass filter. More specifically, the substrate 10 incorporating an ESD protection function is a low pass filter with an ESD protection function.

The wiring pattern 28 electrically connects the inductor element 24, the capacitor element 26, the ESD protection portion 30, and the external electrodes 20, 21, and 22.

In place of the ceramic multilayer substrate 12, insulating substrates other than the ceramic multilayer substrate, such as a ceramic substrate having a single base material layer or a substrate containing materials other than ceramic, such as a resin substrate, can be used. However, as described later, when the ceramic multilayer substrate is used, various kinds of the substrate 10 incorporating an ESD protection function can be easily produced. Thus, the use of the ceramic multilayer substrate is practical.

The external electrodes 20 and 21 and the ESD protection portion 30 are individually formed on each of both sides of a single base material layer in such a manner as to substantially face each other. More specifically, the ESD protection portion 30 is formed near the external electrode 20 serving as an input terminal. Thus, an ESD voltage entering the inside of the substrate 10 incorporating an ESD protection function can be blocked at the entrance.

The ESD protection portion 30 is connected between the external electrode 21 serving as an input terminal and the external electrode 20 serving a ground terminal. The low pass filter constituted by the inductor element 24 and the capacitor element 26 is connected to a latter stage of the ESD protection portion 30, i.e., the external electrode 22 side serving as an output terminal.

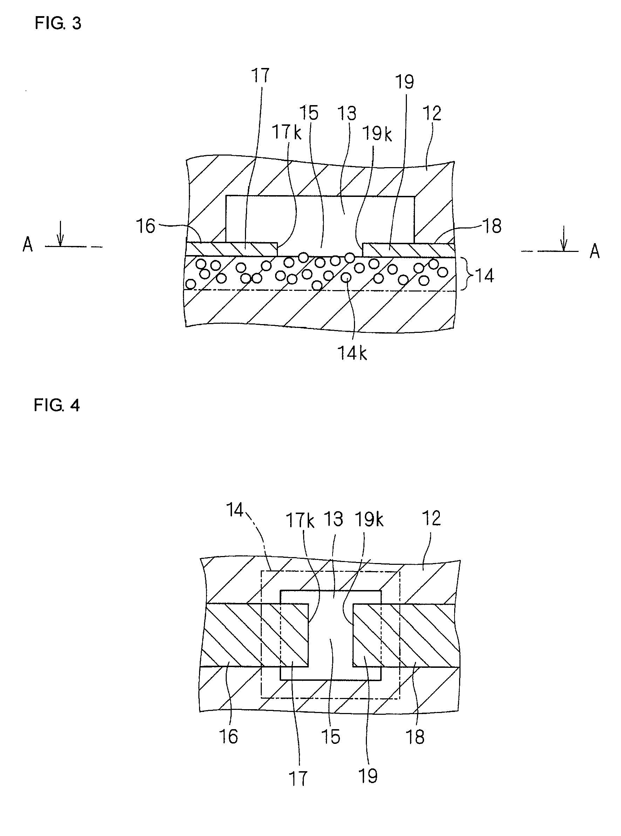

Next, the structure of the ESD protection portion 30 will be described with reference to Figs. 3 and 4. Fig. 3 is a cross section of the ESD protection portion 30. Fig. 4 is a cross sectional view along the A-A line of Fig. 3.

As schematically illustrated in Figs. 3 and 4, in the ESD protection portion 30, facing portions 17 and 19 of discharge electrodes 16 and 18 are disposed in a cavity 13 formed in the ceramic multilayer substrate 12. More specifically, portions (portions exposed to the cavity 13) disposed in the cavity 13 of the discharge electrodes 16 and 18 are the facing portions 17 and 19. In the facing portions 17 and 19 of the discharge electrodes 16 and 18, top ends 17k and 19k face each other and a space 15 is formed between the facing portions 17 and 19 of the discharge electrodes 16 and 18.

As illustrated in Figs. 1 and 2, the discharge electrodes 16 and 18 are electrically connected to the external electrodes 20 and 21, respectively, through the wiring pattern 28. When a voltage equal to or higher than a given value is applied between the external electrodes 20 and 21, discharge occurs between the facing portions 17 and 19 of the discharge electrodes 16 and 18.

As illustrated in Fig. 3, a mixed portion 14 is formed adjacent to the facing portions 17 and 19 of the discharge electrodes 16 and 18 and a portion 15 therebetween. The mixed portion 14 is in contact with the facing portions 17 and 19 of the discharge electrodes 16 and 18 and a base material layer of the ceramic multilayer substrate 12. The mixed portion 14 contains particular metal materials 14k dispersed in a ceramic base material.

As illustrated in Fig. 4, the mixed portion 14 may be widely formed to be larger than the cavity 13. In contrast, although not illustrated, the mixed portion 14 may be formed to be smaller than the cavity 13. For example, the mixed portion 14 may be formed only in a portion of a region adjacent to the cavity.

The mixed portion 14 may be disposed adjacent at least to the facing portions 17 and 19 of the discharge electrodes 16 and 18 and adjacent to a continuous portion between the facing portions 17 and 19. More specifically, the mixed portion 14 may be disposed in such a manner as to connect the facing portions 17 and 19 of the discharge electrodes 16 and 18.

The ceramic material in the base material of the mixed portion 14 may be the same as or different from the ceramic material of the base material layer of the ceramic multilayer substrate 12. When the same material is used, the shrinkage behavior or the like can be easily made the same as that of the ceramic multilayer substrate 12 and the types of materials to be used can be reduced. The metal materials 14k contained in the mixed portion 14 may be the same as or different from that of the discharge electrodes 16 and 18. When the same material is used, the shrinkage behavior or the like can be easily made the same as that of the discharge electrodes 16 and 18 and the types of materials to be used can be reduced.

Since the mixed portion 14 contains the metal materials 14k and a ceramic material, the shrinkage behavior of the mixed portion 14 during firing can be set to an intermediate state between that of the discharge electrodes 16 and 18 including the facing portions 17 and 19 and that of the base material layer of the ceramic multilayer substrate 12. Thus, differences in the shrinkage behavior during firing between the facing portions 17 and 19 of the discharge electrodes 16 and 18 and the base material layer of the ceramic multilayer substrate 12 can be reduced by the mixed portion 14. As a result, defects caused by the separation or the like of the facing portions 17 and 19 of the discharge electrodes 16 and 18 or a variation in the characteristics can be made small. Moreover, since a variation in the space 15 between the facing portions 17 and 19 of the discharge electrodes 16 and 18 also becomes small, a variation in the characteristics, such as a firing potential, can be made small.

The coefficient of thermal expansion of the mixed portion 14 can be set to an intermediate value between that of the discharge electrodes 16 and 18 and that of the base material layer of the ceramic multilayer substrate 12. Thus, differences in the coefficient of thermal expansion of the facing portions 17 and 19 of the discharge electrodes 16 and 18 and the base material layer of the ceramic multilayer substrate 12 can be reduced by the mixed portion 14. As a result, defects caused by the separation or the like of the facing portions 17 and 19 of the discharge electrodes 16 and 18 or aged deterioration of the characteristics can be made small.

By adjusting the amount, type, or the like of the metal materials 14k contained in the mixed portion 14, the firing potential can be set to a desired value. Thus, the firing potential can be set with an accuracy higher than that in the case where the firing potential is adjusted only by the space 15 between the facing portions 17 and 19 of the discharge electrodes 16 and 18.

Next, an example for producing the substrate 10 incorporating an ESD protection function will be described.

### (1) Preparation of materials

For the ceramic materials, materials having a composition mainly containing Ba, Al, and Si were used. Each material was blended and mixed in such a manner as to achieve a given composition, and the mixture was calcined at 800 to 1000°C. The obtained calcined powder was ground in a zirconia ball mill for 12 hours, thereby obtaining ceramic powder. To the ceramic powder, organic solvents, such as toluene · EKINEN, are added and mixed. Furthermore, a binder and a plasticizer are added, and mixed, thereby obtaining a slurry. The slurry thus obtained is molded by a doctor blade method, thereby obtaining a ceramic green sheet having a thickness of 50 µm.

An electrode paste is produced. A solvent was added to a binder resin containing 80 wt% of Cu powder having an average particle diameter of about 2 µm, ethyl cellulose, or the like, and stirred and mixed by three rolls, thereby obtaining an electrode paste.

Further, Cu powder and the ceramic powder after the ceramic material was calcined were blended with a given ratio, and a binder resin and a solvent were similarly added, thereby obtaining a mixed paste of ceramic and metal. In the mixed paste, the resin and the solvent occupied 20 wt% and the ceramic and the Cu powder occupied remaining 80 wt%. As shown in Table I, mixed pastes different in the ceramic/Cu powder volume ratio were prepared.

**[Table 1]**

| | **Volume ratio (vol%)** | |
|---|---|---|
| **Paste No.** | **Ceramic powder** | **Cu powder** |
| 1 | 100 | 0 |
| 2 | 95 | 5 |
| 3 | 90 | 10 |
| 4 | 80 | 20 |
| 5 | 70 | 30 |
| 6 | 50 | 50 |
| 7 | 40 | 60 |
| 8 | 0 | 100 |

Resin pastes only containing resin and a solvent are produced by the same method. For resin materials, resin that decomposes and disappears during firing is used. For example, PET, polypropylene, ethylcellulose, acrylic resin, and the like are mentioned.

### (2) Application of mixed material, electrode, and resin pastes by screen printing

In order to form the mixed portion 14 on a ceramic green sheet, the ceramic/metal mixed paste is applied with a thickness of about 2 µm to 100 µm by screen printing in such a manner as to have a given pattern. When the thickness of the ceramic/metal mixed paste is large, a concave portion prepared beforehand in the ceramic green sheet may be filled with the ceramic/metal mixed paste.

The electrode paste is applied thereonto to form the discharge electrodes 16 and 18 having a discharge gap between the facing portions 17 and 19. Here, the discharge electrodes 16 and 18 were formed so that the thickness of the discharge electrodes 16 and 18 was set to 100 µm and the discharge gap width (size of a gap between the facing portions 17 and 19) was set to 30 µm. Further, the resin paste is applied thereonto in order to form the cavity 13.

Portions other than a portion serving as the ESD protection portion 30, i.e., portions serving as the inductor element 24, the capacitor element 26, the wiring pattern 28, and the external electrodes 20, 21, and 22 are formed in the same manner as in a usual ceramic multilayer substrate. For example, they are formed by forming a penetration hole in a ceramic green sheet by machining or laser beam machining, filling the penetration hole with an electrode paste, or applying an electrode paste onto a ceramic green sheet by screen printing.

### (3) Lamination and pressure bonding

Ceramic green sheets are laminated and pressure-bonded in the same manner as in a usual ceramic multilayer substrate. Here, the sheets are laminated so that the total thickness is set to 0.3 mm.

### (4) Cut and end surface electrode application

The laminate is cut into chips by a micro cutter in the same manner as in chip type electronic components, such as an LC filter.

### (5) Firing

Subsequently, the laminate is fired in an N₂ atmosphere in the same manner as in a usual ceramic multilayer substrate. When a rare gas, such as Ar or Ne, is introduced into the cavity 13 in order to reduce a response voltage to the ESD, firing may be performed in a rare gas atmosphere, such as Ar or Ne, in a temperature range where the shrinkage or sintering of ceramic materials is performed. In the case of electrode materials (e.g., Ag) which do not oxidize, the air atmosphere may be used.

### (6) plating

Ni-Sn electroplating is performed onto the external electrodes 20 and 21 and 22 in the same manner as in chip type electronic components, such as an LC filter.

Thus, the substrate 10 incorporating an ESD protection function is completed whose cross section is as illustrated in Figs. 1, 3, and 4.

The ceramic materials are not limited to the above-described materials insofar the materials are insulating materials. Thus, other materials, such as a substance obtained by adding glass to forsterite or a substance obtained by adding glass to CaZrO₃, may be used. The electrode materials are not limited to Cu and Ag, Pd, Pt, Al, Ni, W, or a combination thereof may be used. The ceramic/metal mixed material is not limited to be formed as a paste and may be formed into a sheet and disposed.

The resin paste was applied in order to form the cavity 13 but other substances, such as carbon, may be used insofar as the substances disappear by firing. A resin film or the like may be placed so as to be adhered to a given portion, instead of forming a paste and printing the same.

100 samples of the substrate 10 incorporating an ESD protection function of the above-described production example were evaluated, by observing the internal cross section, for short-circuit, disconnection after firing, and the occurrence of delamination between the discharge electrodes 16 and 18.

Further, the shrinkage start temperatures of the pastes were compared. Specifically, in order to analyze the shrinkage behavior of each paste simple substance, the paste was dried, the powder thereof was pressed, a pressure-bonded body having a height of 3 mm was produced, and then the measurement was performed by TMA (Thermomechanical analysis). The shrinkage start temperature of ceramic was 885°C similarly as in a paste No. 1.

The discharge responsiveness to the ESD was evaluated. The evaluation of the discharge responsiveness to the ESD was carried out by an electrostatic discharge immunity test specified in IEC Standards, IEC61000-4-2. It was analyzed whether discharge occurs between the discharge electrodes of samples by applying 8 kV by contact discharge. Table 2 below shows ceramic/metal mixed paste conditions and evaluation results.

**[Table 2]**

| | Volume ratio (vol%) | | Paste shrinkage | Short rate | Disconnection rate | Delamination | ESD discharge |
|---|---|---|---|---|---|---|---|
| Sample No. | Ceramic powder | Cu powder | Start temperature | (%) | (%) | Occurrence | Responsiveness |
| 1* | 100 | 0 | 885 | 10 | 6 | Occur | O |
| 2 | 95 | 5 | 880 | 4 | 1 | None | O |
| 3 | 90 | 10 | 840 | 0 | 0 | None | O |
| 4 | 80 | 20 | 820 | 0 | 0 | None | O |
| 5 | 70 | 30 | 810 | 0 | 0 | None | O |
| 6 | 50 | 50 | 780 | 0 | 0 | None | O |
| 7 | 40 | 60 | 745 | 25 | 0 | None | - |
| 8* | 0 | 100 | 680 | 100 | 5 | Occur | - |

In Table 2, the samples marked with * are samples that are outside the range of the invention.

More specifically, when the proportion of metals in the ceramic/metal mixed paste is lower than 5 vol% (paste No.1), the start of shrinkage of the paste is hardly different from that of ceramic and the difference is about 200°C compared with 680°C which is the shrinkage start temperature of an electrode (paste No.8). Therefore, short and disconnection occur in the sample after firing. Moreover, delamination and the separation of the discharge electrodes were observed by observing the inside.

When the proportion of metals in the ceramic/metal mixed paste becomes 10 vo1% or more, the shrinkage start temperature of the pastes becomes close to the shrinkage start temperature of the electrode and is about an intermediate temperature between that of the electrode and that of the ceramic. In this case, short-circuit, disconnection, electrode separation, and delamination were not observed in the samples. The discharge responsiveness to the ESD does not deteriorate due to providing the ceramic/metal mixed paste and is favorable. Moreover, a variation in the gap width between the discharge electrodes was also small.

When the proportion of metals in the ceramic/metal mixed paste becomes large to reach 60 vol% or more, short-circuit between the discharge electrodes occurs after firing due to contact between metal particles in the mixed paste. Thus, such a proportion is not preferable.

By adjusting the metal proportion in the mixed materials to 10 vol% or more and 50 vo1% or lower as in sample No. 3 to 6, the above-described defects do not occur. In particular, the metal proportion is more preferably 30 vol% or more and 50 vol% or lower. More specifically, the content of the metal materials 14k in the mixed portion 14 is preferably 10 vol% or more and 50 vol% or lower and more preferably 30 vol% or more and 50 vol% or lower.

As described above, the material having an intermediate shrinkage behavior between that of the ceramic material and that of the electrode material is obtained by mixing electrode materials and ceramic materials. By disposing the material between the electrodes and ceramic and a discharge gap portion to form a mixed portion, stress to be applied between the discharge electrodes and the ceramic multilayer substrate can be made small and the disconnection of the discharge electrodes or the delamination of the discharge electrode portion, short-circuit caused by electrode separation or a variation in the discharge gap width due to a variation in the shrinkage variation of the electrodes in the cavity, or the like is difficult to occur.

In the substrate 10 incorporating an ESD protection function of Example 1, since the external electrode 21 serving as an input terminal and the external electrode 20 serving a ground terminal are directly connected to each other through the ESD protection portion 30, an ESD signal entering from the external electrode 20 serving as an input terminal is efficiently by-passed to the ground through the ESD protection portion 30. More specifically, the substrate 10 incorporating an ESD protection function incorporates the ESD protection function that functions to the low pass filter provided in a latter stage of the ESD protection portion 30.

The low pass filter is used as a measure against EMI (electro-magnetic interference) for a signal transmission line of both surfaces of a monitor, for example. For such a purpose, a possibility that ESD is applied from the outside is high, and a problem of IC breakage can be suppressed by providing an ESD protection function.

In the substrate 10 incorporating an ESD protection function, by incorporating the low pass filter and the ESD protection portion 30, the mounting area can be made smaller than the case where a simple substance element of a low pass filter and an ESD protection device are used. In the substrate 10 incorporating an ESD protection function, the low pass filter and the ESD protection device are also manufactured by a ceramic sheet lamination method, which results in the fact that an increase in the cost due to the incorporation of the ESD protection function in the ESD low pass filter is small.

The substrate 10 incorporating an ESD protection function can efficiently control an ESD voltage by providing the ESD protection function at a prestage of the low pass filter. Since the capacity between terminals of the ESD protection portion 30 is small, a problem of signal transmission impedance mismatching is also negligible.

### <Example 2>

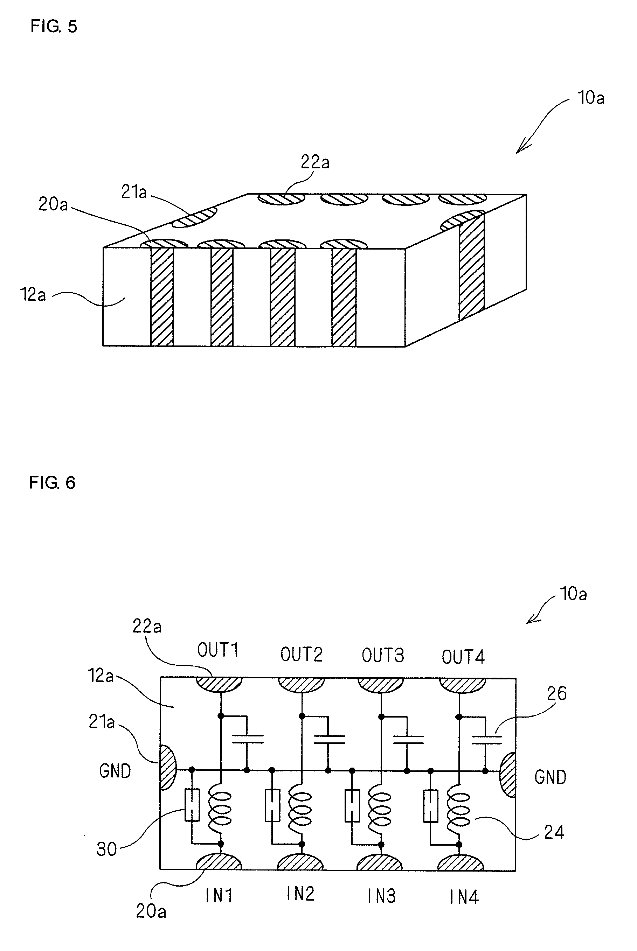

A substrate 10a incorporating an ESD protection function of Example 2 will be described with reference to Figs. 5 and 6. Fig. 5 is a perspective view illustrating the appearance of the substrate 10a incorporating an ESD protection function. Fig. 6 is an electric circuit diagram illustrating the circuit structure of the substrate 10a incorporating an ESD protection function.

The substrate 10a incorporating an ESD protection function of Example 2 is constituted in substantially the same manner as the substrate 10 incorporating an ESD protection function of Example 1. Hereinafter, differences from Example 1 will be mainly described and the same components as those of Example 1 are designated by the same reference symbols.

As illustrated in Fig. 5, in the substrate 10a incorporating an ESD protection function of Example 2, four sets of external electrodes 20a and 22a serving as input terminals and output terminals and two external electrodes 21a serving as ground terminals are provided on the surface of a cubic ceramic multilayer substrate 12a.

As illustrated in Fig. 6, in the ceramic multilayer substrate 12a, the inductor element 24 and the capacitor element 26 constituting a low pass filter and the ESD protection portion 30 are connected to each of the four sets of the external electrodes 20a and 22a similarly as in Example 1. More specifically, the substrate 10a incorporating an ESD protection function of Example 2 is a four-pole low pass filter with an ESD protection function.

The low pass filter, the ESD protection portion 30, and the wiring pattern in the ceramic multilayer substrate 12a can be constituted similarly as in Example 1 and can be manufactured by the same method as in Example 1.

In the substrate 10a incorporating an ESD protection function of Example 2, two or more low pass filters are composited into one chip. Thus, when two or more signal lines are disposed in parallel as in a monitor image data transmission line, a component mounting area can be reduced.

### <Example 3>

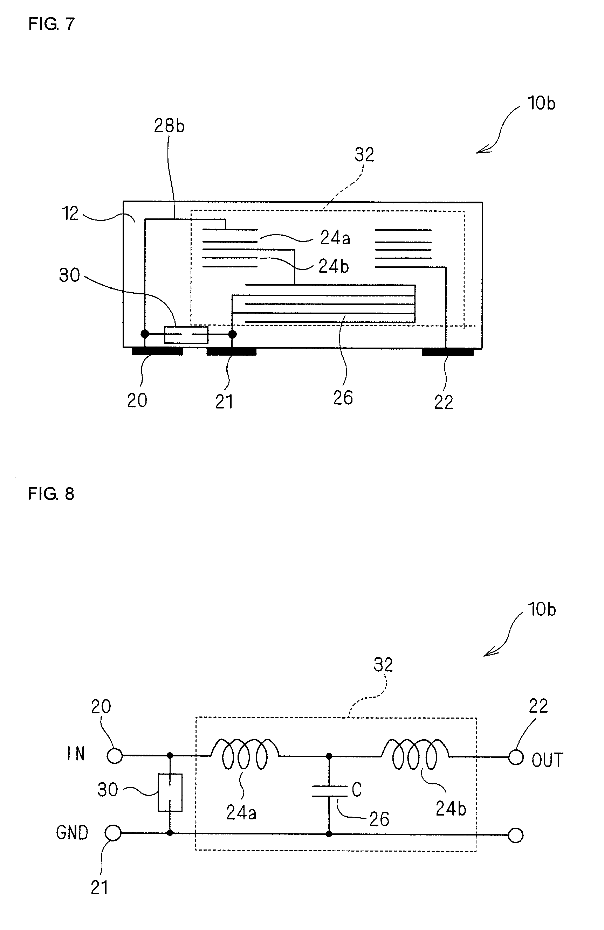

A substrate 10b incorporating an ESD protection function of Example 3 will be described with reference to Figs. 7 and 8. Fig. 7 is an outline view schematically illustrating the cross-sectional structure of the substrate 10b incorporating an ESD protection function. Fig. 8 is an electric circuit diagram illustrating the circuit structure of the substrate 10b incorporating an ESD protection function.

In the substrate 10b incorporating an ESD protection function of Example 3, inductor elements 24a and 24b, the capacitor element 26, a wiring pattern 28b, and the ESD protection portion 30 are formed in the ceramic multilayer substrate 12 similarly as in the substrate 10 incorporating an ESD protection function of Example 1. However, unlike Example 1, the capacitor element 26 is connected to the connecting point of the two inductor elements 24a and 24b, and the inductor elements 24a and 24b and the capacitor element 26 constitute a phase shifter 32.

The ESD protection portion 30 is connected to a prestage of the phase shifter 32. More specifically, the external electrode 20 serving as an input terminal and the external electrode 21 serving as a ground terminal are directly connected to each other through the ESD protection portion 30. Therefore, an ESD signal entering from the external electrode 20 serving as an input terminal is efficiently by-passed to the external electrode 21 serving as a ground terminal through the ESD protection portion 30.

Figs. 7 and 8 illustrate a three dimensional LC filter as the phase shifter 32, which is simply one example. In actual, a filter order or the structure may be changed according to a required phase shift amount.

The phase shifter is used for an antenna end of a cellular phone, for example, and improves the efficiency of electric wave radiation from the antenna by shifting the phase of a high frequency signal to be input and output to/from the antenna. The antenna is likely to be exposed to ESD from the outside and is hard to protect from ESD because a signal to be treated has a high frequency. Furthermore, in order to increase the radiant efficiency from the antenna, impedance matching is very important for the phase shifter, and thus a usual ESD protection device cannot be applied thereto.

In contrast, the ESD protection portion 30 of the substrate 10b incorporating an ESD protection function of Example 3 has a low capacity and a high impedance, and thus can also be applied to the phase shifter 32.

### <Example 4>

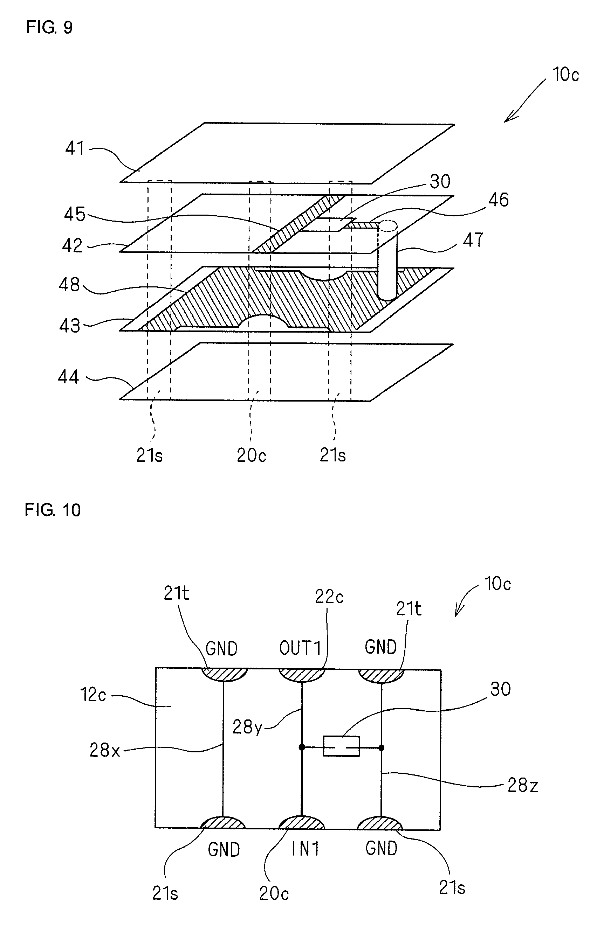

A substrate 10c incorporating an ESD protection function of Example 4 will be described with reference to Figs. 9 and 10. Fig. 9 is a perspective view schematically illustrating the structure of the substrate 10c incorporating an ESD protection function. Fig. 10 is an electric circuit diagram illustrating the circuit structure of the substrate 10c incorporating an ESD protection function.

As illustrated in Figs. 9 and 10, in the substrate 10c incorporating an ESD protection function of Example 4, a second base material layer 42 of a ceramic multilayer substrate has an internal signal line 45 formed as a wiring pattern and the ESD protection portion 30. On the substantially entire surface of a third base material layer 43 of the ceramic multilayer substrate, a ground electrode 48 is formed as a wiring pattern. A radiation electrode 46 at one side of the ESD protection portion 30 of the second base material layer 42 and the ground electrode 48 of the third base material layer 43 are connected to each other by a via-conductor 47.

On one side surface (Front side surface in Fig. 9) of each base material layer from a first base material layer 41 to a fourth base material layer 44 of the ceramic multilayer substrate, two external electrodes 21s serving as ground terminals and one external electrode 20c to which a signal is input are formed. Although not illustrated in Fig. 9, on the other side surface (Back side surface in Fig. 9) of each base material layer from the first base material layer 41 to the fourth base material layer 44 of the ceramic multilayer substrate, two external electrodes 21t serving as ground terminals and one external electrode 22c from which a signal is output are formed. The ground electrode 48 formed on the third base material layer 43 is connected to the external electrodes 21s and 21t serving as ground terminals but is not connected to the external electrodes 20c and 22c to/from which a signal is input and output.

More specifically, the internal signal line 45 of the second base material layer 42 forms a signal line 28y between the external electrodes 20c and 22c serving as an input terminal and an output terminal, respectively. The ground electrode of the third base material layer 43 forms strip lines 28x and 28z between the external electrodes 21s and 21t serving as ground terminals. The ESD protection portion 30 is formed between the signal line 28y and the strip line 28z. The line impedance can be designed to be a desired value.

When an ESD protection element is used for the signal transmission line, it is connected by a signal line in the ESD protection element by cutting a signal line on a printed circuit board in some cases. This is because such a structure produces an advantage of increasing the degree of freedom for design of the printed circuit board. However, in the ESD protection element portion, a discontinuous point of line impedance (usually set to about 50 to 300 Ωs on a printed circuit board) arises, and thus the signal transmission quality deteriorates.

In contrast, since the strip line is formed with the ceramic multilayer substrate in the substrate 10C incorporating an ESD protection function of Example 4 and the line impedance can be matched with the impedance of a printed circuit board, the degradation of signal transmission quality can be prevented.

### <Example 5>

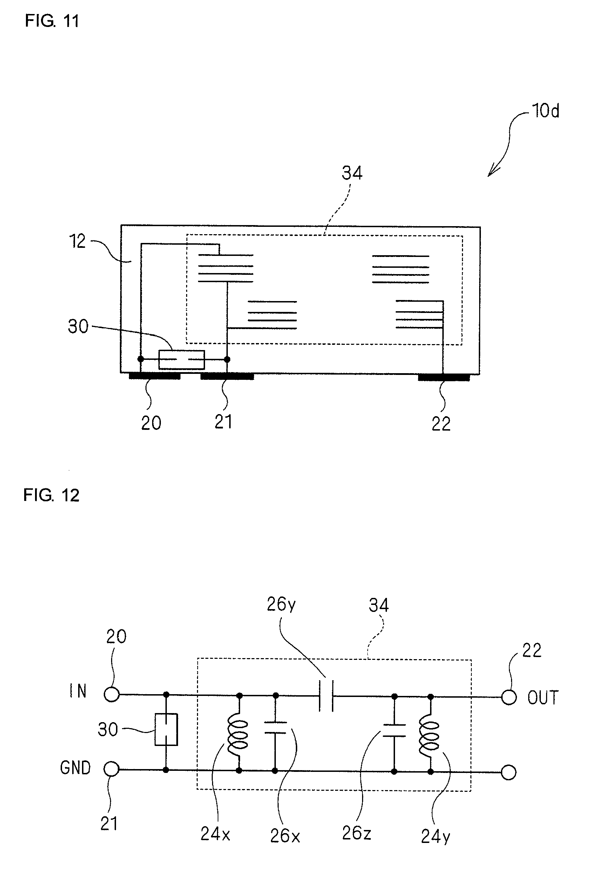

A substrate 10d incorporating an ESD protection function of Example 5 will be described with reference to Figs. 11 and 12. Fig. 11 is an outline view schematically illustrating the cross-sectional structure of the substrate 10d incorporating an ESD protection function. Fig. 12 is an electric circuit diagram illustrating the circuit structure of the substrate 10d incorporating an ESD protection function.

As illustrated in Figs. 11 and 12, the substrate 10d incorporating an ESD protection function of Example 5 incorporates a resonant circuit 34 and the ESD protection portion 30 in the ceramic multilayer substrate 12.

The ESD protection portion is connected between the external electrode 21 serving as an input terminal and the external electrode 20 serving as a ground terminal. The resonant circuit 34 is connected to a latter stage of the ESD protection portion 30, i.e., the external electrode 22 side serving as an output terminal.

Figs. 11 and 12 illustrate a bandpass filter using inductor elements 24x and 24y and capacitor elements 26x, 26y, and 26z as the resonant circuit 34. However, such a structure is one example, and a resonant circuit using a strip line using electrode wiring may be used, for example, in place of the above.

The resonant circuit is used for the antenna end of short-distance communication using magnetic field combination, for example, and is used in order to extract, with a high sensitivity, a magnetic field signal to be input and output to/from an antenna. Such an antenna portion is likely to be exposed to ESD from the outside, and is a portion which is hard to protect from ESD because a signal to be treated has a high frequency.

The substrate 10d incorporating an ESD protection function of Example 5 has an advantage in that since the ESD protection portion 30 has a low capacity and a high impedance, the Q of such a resonant circuit does not reduce.

### <Example 6>

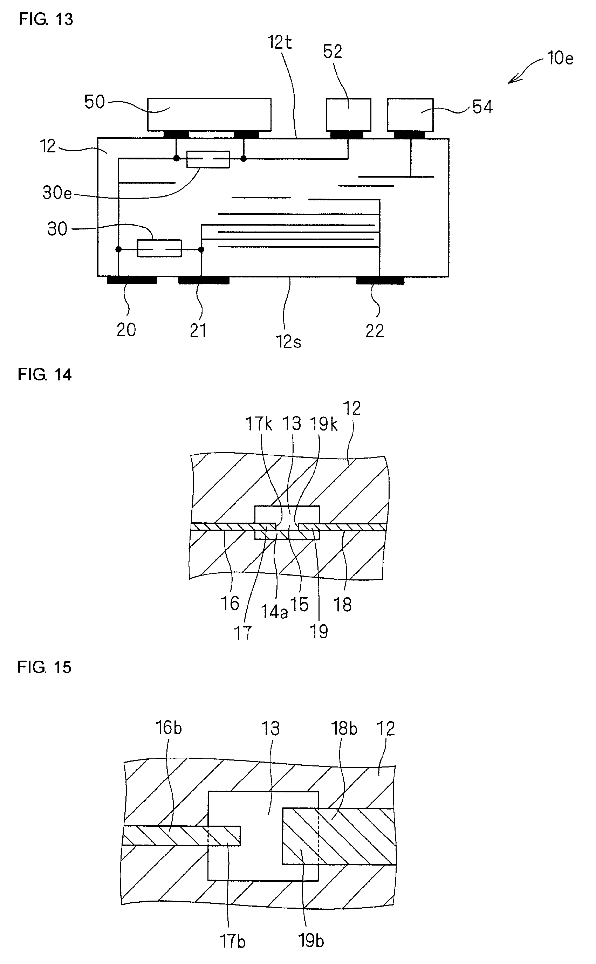

A substrate 10e incorporating an ESD protection function of Example 6 will be described with reference to Fig. 13. Fig. 13 is an outline view schematically illustrating the cross-sectional structure of the substrate 10e incorporating an ESD protection function.

As illustrated in Fig. 13, the substrate 10e incorporating an ESD protection function of Example 6 is a module component in which an IC 50 or mounting components 52 and 54 other than the IC are mounted on the upper surface 12t of the ceramic multilayer substrate 12. Similarly as in Example 1, an inductor element, a capacitor element, a wiring pattern, the ESD protection portion 30, an ESD protection portion 30e are incorporated in the ceramic multilayer substrate 12 and the external electrodes 20, 21, and 22 are formed on the lower surface 12s of the ceramic multilayer substrate.

Fig. 13 illustrates the case where the components are mounted only on one side of the ceramic multilayer substrate 12, but components may be mounted on both surfaces of the ceramic multilayer substrate 12, may be mounted in a concave portion formed in the ceramic multilayer substrate, or may be mounted on the side surface of the ceramic multilayer substrate.

Since the substrate 10e incorporating an ESD protection function of Example 6 is a modular component having the ESD protection portions 30 and 30e in the ceramic multilayer substrate 12, the substrate 102 is advantageous in the respect of the cost and the occupied volume compared with the case where the same function is constituted by separate components.

The ESD protection portion 30e is formed in such a manner as to be disposed on the side opposite to a base material layer serving as the upper surface 12t of the ceramic multilayer substrate 12 and directly under the IC 50 to be mounted on the upper surface 12t of the ceramic multilayer substrate 12. Thus, by disposing the ESD protection portion 30e directly under the IC 50, the ESD protection performance to the IC 50 can be increased.

The external electrodes 20 and 21 and the ESD protection portion 30 to be connected to the external electrodes 20 and 21 are formed on both sides of a single base material layer of the ceramic multilayer substrate in such a manner as to substantially face each other. Thus, by disposing the ESD protection portion 30 near the external electrodes 20 and 21 serving as module terminal, an ESD voltage entering the inside of the module can also be blocked at the module entrance.

Since the design flexibility of the substrate 10e incorporating an ESD protection function of Example 6 is high, various needs for ESD protection can be satisfied. In particular, since the volume of the ESD protection portion is small, the ESD protection portion can be disposed on various portions in the module.

Next, modifications 1 to 6 will be described.

### <Modification 1>

An ESD protection portion of a modification 1 will be described with reference to Fig. 14. The ESD protection portion of the modification 1 has substantially the same structure as the ESD protection portion 30 of Example 1. Hereinafter, differences will be mainly described and the same components are designated by the same reference symbols.

Fig. 14 illustrates the cross section of the ESD protection portion. As illustrated in Fig. 14, a mixed portion 14a is formed only directly under the cavity 13 in the ESD protection portion. More specifically, when viewed in a direction (vertical direction in Fig. 14) in which the facing portions 17 and 19 of the discharge electrodes 16 and 18 and the mixed portion 14 are overlapped with each other, the mixed portion 14a is formed in contact the periphery of the cavity 13 and only inside the periphery of the cavity 13.

By forming the mixed portion 14a only directly under the cavity 13 as described above, a variation in the shape of the cavity 13 becomes small. As a result, a variation in the space 15 between the facing portions 17 and 19 of the discharge electrodes 16 and 18 becomes small, and thus the firing potential can be set with a favorable accuracy.

### <Modification 2>

An ESD protection portion of a modification 2 will be described with reference to Fig. 15. Fig. 15 is a cross sectional view parallel to discharge electrodes 16b and 18b similarly as in Fig. 4.

As illustrated in Fig. 15, the width of a facing portion 19b of one discharge electrode 18b disposed in the cavity 13 is larger than the width of a facing portion 17b of the other discharge electrode 16b disposed in the cavity 13. The one discharge electrode 18b is connected to the ground side. The other discharge electrode 18b is connected to a circuit side to be protected from static electricity.

When the width of the facing portion 17b of the discharge electrode 16b to be connected to the circuit side is smaller than the width of the facing portion 19b of the discharge electrode 18b to be connected to the ground side, discharge from the circuit side to the ground side is likely to occur. By enlarging the electrode area of the discharge electrode 18b at the ground side, a connection resistance to the ground can be made small and discharge from the circuit side to the ground side is more likely to occur. Therefore, the ESD protection portion of the modification 2 can certainly prevent breakage of the circuit.

### <Modification 3>

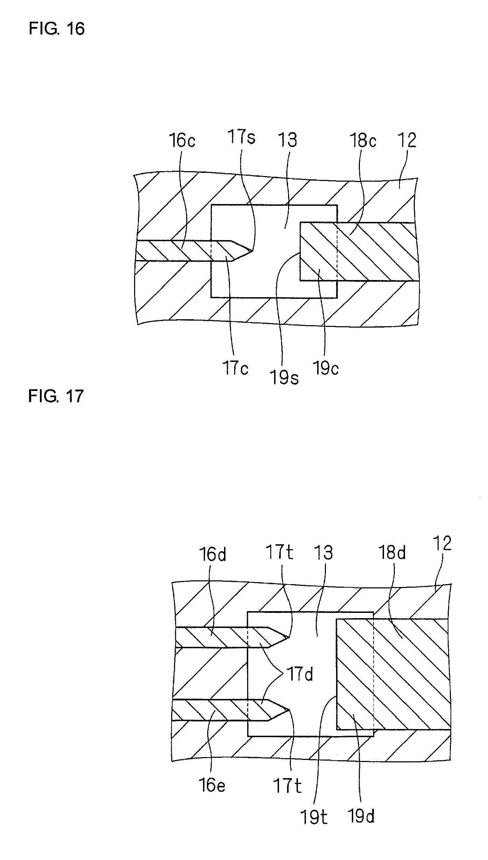

An ESD protection portion of a modification 3 will be described with reference to Fig. 16. Fig. 16 is a cross sectional view parallel to discharge electrodes 16c and 18c.

As illustrated in Fig. 16, a top end 19s of a facing portion 19c of one discharge electrode 18c disposed in the cavity 13 is straight and flat but a top end 17c of a facing portion 17c of the other discharge electrode 16c disposed in the cavity 13 is sharp. The one discharge electrode 18c is connected to the ground side. The other discharge electrode 16c is connected to a circuit (not illustrated) side to be protected from static electricity.

When the top end 17s of the facing portion 17c of the discharge electrode 16c is sharp, discharge is likely to occur. Therefore, the ESD protection portion of the modification 3 can certainly prevent breakage of the circuit.

### <Modification 4>

An ESD protection portion of a modification 4 will be described with reference to Fig. 17. Fig. 17 is a cross sectional view parallel to discharge electrodes 16d, 16e, and 18d.

As illustrated in Fig. 17, two discharge electrodes 16d and 16e and one discharge electrode 18d form a pair and facing portions 17d of the two discharge electrodes 16d and 16e and a facing portion 19d of the one discharge electrode 18d are disposed in the cavity 13. A top end 19t of the facing portion 19d of the one discharge electrode 18d is straight and flat but top ends 17t of the facing portions 17d of the other discharge electrodes 16d and 16e are sharp. The one discharge electrode 18d is connected to the ground side. The other discharge electrodes 16d and 16e are connected to a circuit side to be protected from static electricity.

When the top ends 17t of the facing portions 17d of the discharge electrodes 16d and 16e at the circuit side are sharp, discharge is likely to occur. Therefore, the ESD protection portion of the modification 4 can certainly prevent breakage of the circuit.

In the ESD protection portion of the modification 4, discharge separately occurs between the discharge electrode 18d and the one discharge electrode 16d and between the discharge electrode 18d and the other discharge electrode 16e, and thus the discharge electrodes 16d and 16e can be individually connected to different circuits for use. In this case, the number of the ESD protection devices in an electronic device can be reduced and the size of the circuit in the electronic device can also be reduced.

### <Modification 5>

For the ceramic multilayer substrate incorporating the ESD protection portion, a non-shrinkage substrate is used in which shrinkage suppression layers and base material layers are alternately laminated.

The base material layer is obtained by sintering one or two or more ceramic green sheets containing a first ceramic material and governs the substrate characteristics of the ceramic multilayer substrate. A constraining layer contains one or two or more ceramic green sheets containing a second ceramic material.

The thickness of each base material layer is preferably 8 µm to 100 µm after firing. The thickness after firing of each base material layer is not always limited to the range mentioned above and is preferably set to be equal to or lower than the maximum thickness with which each material layer can be constrained by the constraining layer during firing. The thickness of each of the base material layers is not necessarily the same.

Used as the first ceramic material is a substance having a portion (e.g., glass ingredients) penetrating the constraining layer during firing. As the first ceramic material, LTCC (Low Temperature Co-Fired Ceramic) that can be fired at a relatively low temperature, e.g., 1050°C is preferably used in order to achieve simultaneous firing with a conductive pattern containing low melting metals, such as silver or copper. Specifically, glass ceramic in which alumina and borosilicate glass are mixed, Ba-Al-Si-O-based ceramic that generate glass ingredients during firing, or the like can be used.

The second ceramic material is adhered by a portion of the first ceramic material penetrating from the base material layer, and thus the constraining layer is solidified and the base material layer and the constraining layer adjacent to each other are bonded.

As the second ceramic material, alumina or zirconia can be used. The constraining layer contains the second ceramic material in a non-sintered state having a sintering temperature higher than that of the first ceramic material. Therefore, the constraining layer exhibits a function of suppressing the shrinkage in a plane direction in a firing process to the base material layer. As described above, the constraining layer is adhered and bonded by the penetration of a portion of the first ceramic material. Therefore, strictly, depending on the state and a desired constraining force of the base material layer and the constraining layer, and sintering conditions, the thickness after firing of the constraining layer is preferably about 1 µm to 10 µm.

The electrode materials of the discharge electrodes, internal electrode, or via electrode may be any material insofar as the material contains, as the main ingredients, conductive ingredients that can be simultaneously fired with the base material layer and various known materials can be used. Specifically, Cu, Ag, Ni, Pd, oxides thereof, and alloy ingredients thereof can be used.

### <Conclusion>

As described above, since the mounting area can be reduced by integrating the ESD protection portion that functions as an ESD protection element with the insulating substrate, the size of the circuit is easily reduced. Moreover, by providing the ESD protection portion in the insulating substrate, the wiring distance can be shortened and the ESD protection function can be sufficiently demonstrated.

When the ceramic multilayer substrate is used for the insulating substrate, a substrate incorporating an ESD protection function can be produced without increasing the processes compared with the case where the ESD protection device is manufactured using the ceramic multilayer substrate.

In the ESD protection portion, when the mixed portion is formed by disposing a material having an intermediate shrinkage behavior between that of ceramic materials and that of electrode materials by mixing metal materials and ceramic materials between the discharge electrodes and the ceramic multilayer substrate and the gap portion between the top ends of the discharge electrodes, stress acting between the discharge electrodes and the ceramic multilayer substrate can be made small, disconnection of the discharge electrodes or delamination of the discharge electrodes, separation of the discharge electrodes or a variation in the discharge gap width due to a variation in the shrinkage of the discharge electrodes in the cavity, short-circuit, or the like is hard to occur. Therefore, the firing potential in the ESD protection portion can be set with a favorable accuracy and the reliability of the ESD protection function can be increased.

Further, the capacity of the ESD protection portion is as small as about 0.1 pF or lower and, in addition, the impedance between terminals is sufficiently high even in a frequency range of 300 MHz to several GHz of and the characteristics of other circuits are not affected. Thus, the ESD protection portion can be applied to a prestage of an LC filter for high frequencies and can sufficiently demonstrate the ESD protection function.

In a former varistor or zener diode, the electrostatic capacity is at most about 2 pF at the smallest and an applicable frequency range is up to about 300 MHz. In contrast, since the electrostatic capacity of the ESD protection portion of the substrates incorporating an ESD protection function of the Examples of the invention can be reduced up to, for example, 1/20, an applicable frequency range extends by about 20 times. More specifically, the ESD protection portion can be applied to a high frequency range of 300 MHz to 6 GHz.

The high frequency IC is a component which is hard to protect from ESD in that the high frequency IC is easily broken by static electricity and, in contrast, when a capacity of several pF is given, normal operation cannot be carried out. However, since the electrostatic capacity of the ESD protection portion of the substrates incorporating an ESD protection function of the Examples of the invention is as small as about 0.1 pF, for example, and thus the ESD protection portion can be applied to protect the high frequency IC.

By forming the ESD protection portion serving as an ESD protection element in the ceramic multilayer substrate on which an IC is mounted, the distance between the ESD protection portion and the IC can be shortened and deterioration of the protection function due to the wiring impedance therebetween hardly arises.

The present invention is not limited to the above-described embodiments and can be carried out while variously modifying.

For example, a circuit element containing not only an inductor (L) or a capacitor (C) but also a resistance (R) may be formed in the insulating substrate.

- 10,: 10a to 10e incorporating an ESD protection function
- 12, 12a: ceramic multilayer substrate (insulating substrate, ceramic substrate)
- 13: cavity
- 14, 14a: mixed portion
- 14k: metal material
- 15: space
- 16, 16b, 16c, 16d,: 16e discharge electrode
- 17, 17b, 17c, 17d: facing portion
- 17k, 17s, 17t top: end
- 18, 18b, 18c, 18d: discharge electrode
- 19, 19b, 19C, 19d: facing portion
- 19k, 19s, 19t top: end
- 20, 20a, 20c: external electrode (signal input portion)
- 21, 21a, 21s, 21t: external electrode
- 22, 22a, 22c: external electrode
- 24, 24a, 24b, 24x,: 24y inductor element (circuit element)
- 26, 26x, 26y, 26z: capacitor element (circuit element)
- 28, 28b: wiring pattern
- 30, 30e: ESD protection portion
- 50: IC

## Claims

1. A substrate incorporating an ESD protection function, comprising:
an insulating substrate incorporating at least one of a circuit element or a wiring pattern;
at least one cavity formed in the insulating substrate; and
at least one pair of discharge electrodes having facing portions disposed in the cavity so that the top ends thereof face each other with a space and being electrically connected to the circuit element or the wiring pattern.

2. The substrate incorporating an ESD protection function according to claim 1, wherein the insulating substrate has a mixed portion disposed near the surface where the discharge electrodes are provided, the mixed portion is disposed adjacent at least to the facing portions of the discharge electrodes and a portion between the facing portions, the mixed portion contains a metal material and an insulating material constituting the insulating substrate.

3. The substrate incorporating an ESD protection function according to claim 2, wherein the mixed portion is disposed adjacent only to the facing portions and the space between the facing portions.

4. The substrate incorporating an ESD protection function according to claim 2 or 3, wherein, when viewed in the direction in which the facing portions of the discharge electrodes and the mixed portion are overlapped with each other, the mixed portion is formed in contact with the periphery of the cavity and only inside the periphery.

5. The substrate incorporating an ESD protection function according to any one of claims 1 to 4, wherein the insulating substrate is a ceramic substrate.

6. The substrate incorporating an ESD protection function according to any one of claims 1 to 5, wherein the cavity and the discharge electrode are formed near a signal input portion of the insulating substrate.

7. The substrate incorporating an ESD protection function according to any one of claims 1 to 6, wherein the circuit element or the wiring pattern constitute a high frequency circuit.

8. The substrate incorporating an ESD protection function according to any one of claims 1 to 7, wherein an IC is mounted on the insulating substrate or in the insulating substrate.
